# EUROPÄISCHE PATENTSCHRIFT

(11) **EP 1 004 059 B1**
(45) Veröffentlichungstag und Bekanntmachung des Hinweises auf die Patenterteilung: **14.08.2002**
(21) Anmeldenummer: 98951166.2
(22) Anmeldetag: 19.08.1998
(51) Int. Cl.: G05B 9/02, G01R 31/327

(54) **VERFAHREN ZUR ERKENNUNG VON FEHLSCHALTUNGEN EINES ERSTEN RELAIS**
METHOD FOR DETECTING MALFUNCTIONS OF A FIRST RELAY
PROCEDE POUR LA DETECTION DES CONNEXIONS DEFECTUEUSES D'UN PREMIER RELAIS

(30) Priorität: 22.08.1997 DE 19736731; 12.02.1998 DE 19805658
(43) Veröffentlichungstag der Anmeldung: 31.05.2000
(73) Patentinhaber: ROBERT BOSCH GMBH, 70442 Stuttgart (DE)
(72) Erfinder: KOCH, Stefan, D-77855 Achern (DE); KREMSER, Rolf, D-77743 Neuried (DE); SOELLNER, Michael, D-77839 Lichtenau (DE)
(86) Internationale Anmeldenummer: DE9802410
(87) Internationale Veröffentlichungsnummer: WO9910780

(56) Entgegenhaltungen:
- EP-A- 0 563 683
- EP-A- 0 651 489
- GB-A- 2 162 391
- US-A- 5 136 280
- US-A- 5 243 291
- PATENT ABSTRACTS OF JAPAN vol. 097, no. 012, 25. Dezember 1997 & JP 09 213471 A (SANYO ELECTRIC CO LTD), 15. August 1997

## Beschreibung

### Stand der Technik

Die Erfindung geht aus von einem Verfahren zur Erkennung von Fehlschaltungen eines ersten Relais, dessen Schaltmittel in Reihe mit einem Verbraucher geschaltet ist, der im Oberbegriff des Anspruchs 1 definierten Gattung.

Aus der DE 31 35 888 C2 ist ein Verfahren bekannt, welches zur Erkennung von Fehlschaltungen von Relais dient, dessen Schaltmittel in Reihe mit einem Verbraucher geschaltet ist und je nach Schaltstellung nach Maßgabe von Schaltbefehlen die Verbindung zum Verbraucher unterbricht oder schließt. Wird eine Fehlschaltung erkannt, entweder bei den Schaltbefehlen oder bei den Relais, wird der motorische Verbraucher so mit Potential versorgt, daß er am Anlaufen gehindert ist. Vorliegende Fehlererkennung beruht auf der Erkennung bestimmter Potentiale und deren recht komplexen Auswertung.

### Vorteile der Erfindung

Das erfindungsgemäße Verfahren zur Erkennung von Fehlschaltungen eines ersten Relais mit den kennzeichnenden Merkmalen des Anspruchs 1 hat demgegenüber den Vorteil, eine einfache und zuverlässige Lösung zur Verfügung zu stellen, bei welcher ein Relaistest mit Hilfe einer in einem elektronischen Steuergerät implementierten Strommessung durchgeführt wird. In vorteilhafter Weise können somit alle Relais angesteuert werden, ohne daß einer der als Verbraucher vorgesehenen Aktuatoren bewegt werden muß.

Bei dem Verfahren nach der Erfindung wird dazu prinzipiell ein durch einen die Schaltmittel beinhaltenden Stromkreis fließender Strom erfaßt und eine Fehlfunktion des Relais, insbesondere ein Kleben des Schaltmittels, erkannt, wenn die Stromstärke nicht der gemäß der angewählten Schaltstellung zu erwartenden Stromstärke entspricht.

Durch die in den weiteren Ansprüchen niedergelegten Maßnahmen sind vorteilhafte Weiterbildungen und Verbesserungen des im Anspruch 1 angegebenen Verfahrens möglich.

Nach einer besonders zweckmäßigen Weiterbildung der Erfindung ist wenigstens ein zweites Relais vorgesehen, das eine erste Klemme des Stromkreises durch Umschaltung auf wenigstens zwei verschiedene Potentiale legen kann, und eine zweite Klemme des Stromkreises auf einem ersten der beiden Potentiale liegt, vorgesehen, und erfindungsgemäß wird an das zweite Relais ein Schaltsignal zur Verbindung der ersten Klemme mit dem zweiten Potential abgegeben und an das erste Relais wird ein Schaltsignal zum Öffnen gegeben, und ein einen Fehler der beiden Relais kennzeichnendes erstes Fehlersignal wird dann abgegeben, wenn ein Stromfluß in dem Stromkreis erkannt wird.

In vorteilhafter Ausgestaltung dieser erfindungsgemäßen Weiterbildung ist vorgesehen, daß an das zweite Relais ein Schaltsignal zur Schaltung der ersten Klemme an das erste Potential gegeben wird und an das erste Relais ein Schaltsignal zum Schließen gegeben wird, wenn im vorhergehenden Schritt kein Fehler erkannt wurde, und daß ein einen Fehler der beiden Relais kennzeichnendes Fehlersignal abgegeben wird, wenn ein Stromfluß im Stromkreis erkannt wird.

In einer weiteren vorteilhaften Ausgestaltung der Erfindung ist vorgesehen, daß mehrere Verbraucher mit zugeordneten ersten Relais parallel zu den beiden Klemmen geschaltet sind und Fehler in einzelnen und/oder mehreren der Relais erkannt werden.

In besonders vorteilhafter und zweckmäßiger Weiterbildung der Erfindung ist ein drittes Relais vorgesehen, über das die zweite Klemme mit einem der beiden Potentiale verbunden werden kann. Entsprechend einer vorteilhaften Anwendung dieser erfindungsgemäßen Weiterbildung wird durch Schalten des dritten Relais eine Fehlfunktion des zweiten Relais und umgekehrt festgestellt.

Eine weitere vorteilhaften Ausgestaltung der Erfindung ist gekennzeichnet durch die Verwendung eines Halbleiterschalters an Stelle wenigstens eines der Relais.

### Zeichnung

Die Erfindung ist anhand eines in der Zeichnung dargestellten Ausführungsbeispiels in der nachfolgenden Beschreibung näher erläutert. Die einzige Figur zeigt schematisch ein Blockschaltbild einer Aktuatoransteuerung, dargestellt anhand von Motoren, bei der das erfindungsgemäße Verfahren vorteilhaft einsetzbar ist.

### Beschreibung des Ausführungsbeispiels

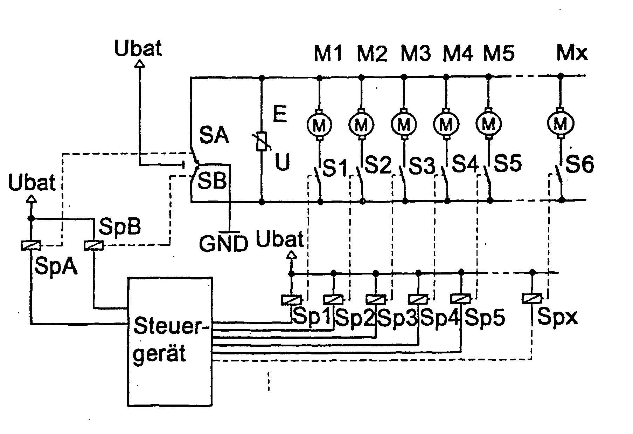

In Fig. 1 ist schematisch in einem Blockschaltbild der Aufbau einer Aktuatoränsteuerung dargestellt, bei dem die Aktuatoren Motore M1, ..., Mx sind. Diese Motore M1, ..., Mx werden über erste Relais 1 - X, bestehend aus den jeweils zugehörigen Relaisspulen Sp1 bis Spx und den als Schaltmittel dienenden Relaiskontakten S1 bis Sx, an die an den Leitungen 1 bzw. 2 anliegenden Potentiale geschaltet. Mit Hilfe eines zweiten Relais A, bestehend aus der Relaisspule SpA und dem zugehörigen Relaiskontakt SA, wird eine Leitung 7 mit zwei verschiedenen Potentialen, im dargestellten Beispiel entweder mit GND oder Ubat, verbunden. Dementsprechend liegt dieses unterschiedliche Potential an der einen Seite der Motoren M1, ..., Mx an. Mit Hilfe eines weiteren Relais B, bestehend aus der Relaisspule SpB und dem zugehörigen Relaiskontakt SB, wird eine Leitung 6 mit zwei verschiedenen Potentialen, im dargestellten Beispiel entweder mit GND oder Ubat, verbunden. Dementsprechend liegt dieses unterschiedliche Potential an der zweiten Seite der Motoren M1, ..., Mx an. Auf diese Weise kann der Rechts- oder Linkslauf der Motoren bestimmt werden. Die Ansteuerung der Relaisspulen Sp1 bis Spx, SpA und SpB erfolgt von einem Steuergerät aus, welches die entsprechenden Schaltsignale bzw. Schaltbefehle abgibt, um die als Schaltmittel dienenden Relaiskontakte in die entsprechenden Schaltstellungen zu verbringen. Die Einwirkung der Relaisspulen auf die zugehörigen Relaiskontakte ist durch gepunktete Linien angedeutet.

Zur Durchführung des erfindungsgemäßen Verfahrens ist im Steuergerät bevorzugt ein Mikrokontroller vorgesehen sowie eine in der Figur nicht näher dargestellte Vorrichtung zur Summenstrommessung aller Aktuatoren, beispielsweise über einen Shunt-Widerstand in der Leitung zwischen den Relaiskontakten SA/SB, Leitung 5 und dem GND-Potential, oder einer Strommessung jedes Pfades getrennt oder einer Mischung aus beidem.

Zur Überprüfung der in der Figur dargestellten Relais, ob diese beispielsweise in geschlossenem Zustand 'Kleben', genügen die nachfolgend aufgeführten Testschritte. Dabei ist von folgender, in der Figur dargestellter Grundstellung der Relaiskontakte ausgegangen: die Relaiskontakte S1 bis Sx sind offen, die Relaiskontakte SA und SB liegen auf GND-Potential.

Der erste Testschritt beinhaltet das Ansteuern der Relaisspule SpA und damit das Schließen des Relaiskontaktes SA nach Leitung 8. Damit liegt dann auf Leitung 7 das Potential Ubat an den Motoren M1, ..., Mx an. Ist nun eines der Relaiskontakte S1 bis Sx fehlerhaft geschlossen, dann mißt der Mikrokontroller einen Strom, der größer als Null, allgemein: größer als ein erwarteter Sollwert, ist und detektiert damit, daß eines der Relais 1 bis x, bestehend aus Relaisspulen Sp1 bis Spx sowie zugehörigen Relaiskontakten S1 bis Sx, 'hängt in geschlossener Position )gegen Leitung 2). Mißt das Steuergerät bzw. der Mikrokontroller keinen derartigen Strom, dann sind alle den Motoren zugeordnete erste Relais 1 - x offen oder das Relais A, bestehend aus Relaisspule SpA sowie zugehörigem Relaiskontakt SA, 'hängt' gegen Leitung 5. Nach diesem ersten Testschritt kehrt die Anordnung nach Beendigung der Ansteuerung in die vorstehend beschriebene Grundstellung zurück.

Die vom Steuergerät für Testzwecke vorgenommene Ansteuerung der Relais erfolgt solange, daß die Relais sicher anziehen. Andererseits wird die Ansteuerung nicht so lange aufrecht erhalten, um somit bei einer Fehlfunktion der Relais eine Aktuatorbewegung so minimal wie irgend möglich zu halten. Bei der Wahl der erforderlichen Ansteuerzeit werden die Daten der verwendeten Relais beachtet.

In einem optionalen Testschritt erfolgt das Ansteuern der Relaisspule SpB und damit das Schließen des Relaiskontaktes SB nach Leitung 8. Damit liegt dann auf Leitung 6 das Potential Ubat an den Motoren M1, ..., Mx an. Ist nun eines der Relaiskontakte S1 bis Sx fehlerhaft geschlossen, dann mißt der Mikrokontroller einen Strom, der größer als Null, allgemein: größer als ein erwarteter Sollwert, ist und detektiert damit, daß eines der Relais 1 bis x, bestehend aus Relaisspulen Sp1 bis Spx sowie zugehörigen Relaiskontakten S1 bis Sx, 'hängt in geschlossener Position (gegen Leitung 2). Mißt das Steuergerät bzw. der Mikrokontroller keinen derartigen Strom, dann sind alle den Motoren zugeordnete erste Relais 1 - x offen oder das Relais B, bestehend aus Relaisspule SpB sowie zugehörigem Relaiskontakt SB, 'hängt' gegen Leitung 5. Nach diesem optionalen Testschritt kehrt die Anordnung nach Beendigung der Ansteuerung in die vorstehend beschriebene Grundstellung zurück.

Mit diesem ersten bzw. optionalen Testschritt werden alle Relais überprüft. Wird kein Strom gemessen und damit Fehlverhalten festgestellt, kann auf weitere Tests verzichtet werden.

Ein zweiter Testschritt besteht nun darin, daß ein beliebiges Relais 1 bis x, bestehend aus den jeweils zugehörigen Relaisspulen Sp1 bis Spx und den Relaiskontakten S1 bis Sx, angesteuert wird. Ist nun eines der Relais A oder B, bestehend aus Relaisspule SpA/SpB sowie zugehörigem Relaiskontakt SA/SB, fehlerhaft geschlossen, dann mißt der Mikrokontroller einen Strom, der größer als Null ist. Damit wird detektiert, daß eines der Relais A bzw. B 'hängt' in Position gegen das Potential Ubat auf Leitung 8. Nach diesem zweiten Testschritt kehrt die Anordnung nach Beendigung der Ansteuerung in die vorstehend beschriebene Grundstellung zurück.

Der Test bezüglich des 'Hängens' der Relais 1 - X in offener Position bzw. der Relais A und B gegen GND-Potential erfolgt über eine Mindeststromerkennung im Normalbetrieb des Systems, wobei bei der Aktuatoransteuerung der Mikrokontroller keinen Strom mißt. Daraufhin erfolgt die Fehlerdetektion.

Der Test entsprechend dem erfindungsgemäßen Verfahren kann beliebig durchgeführt werden, beispielsweise nach dem Einschalten der Zündung bei einem Kraftfahrzeug oder zyklisch oder in anderer geeigneter Weise. Das Ergebnis steht für Diagnosezwecke zur Verfügung und kann in die Funktionalität des Steuergerätes eingebunden werden. So kann z.B. dafür gesorgt werden, daß bei der Feststellung einer Relaisfehlfunktion keine Ansteuerung des entsprechenden Aktuators mehr erfolgt.

Das erfindungsgemäße Verfahren kann vorteilhafterweise auch dann eingesetzt werden, wenn die Verwendung eines Halbleiterschalters an Stelle wenigstens eines der Relais vorgesehen ist. Als Halbleiterschalter kann beispielsweise ein MOSFET-Transistor Verwendung finden.

Das erfindungsgemäße Verfahren ermöglicht einen Relaistest ohne Bewegung der Aktuatoren, vorausgesetzt die Relais sind in Ordnung. Es bringt darüber hinaus eine wesentliche Zeitersparnis, da nicht alle Relais zum Test angesteuert werden müssen.

## Patentansprüche

1. Verfahren zur Erkennung von Fehlschaltungen eines ersten, an Gleichspannung betriebenen Relais, dessen Schaltmittel in Reihe mit einem Verbraucher geschaltet ist und je nach Schaltstellung nach Maßgabe von Schaltbefehlen die Verbindung zum Verbraucher unterbricht oder schließt,
**dadurch gekennzeichnet, daß**
ein durch einen die Schaltmittel beinhaltenden Stromkreis fließender Strom erfaßt und eine Fehlfunktion des ersten Relais, insbesondere ein Kleben des Schaltmittels, erkannt wird, wenn die Stromstärke nicht der gemäß der angewählten Schaltstellung zu erwartenden Stromstärke entspricht, weiterhin wenigstens ein zweites, gleichfalls an Gleichspannung betriebenes Relais vorgesehen ist, das eine erste Klemme des Stromkreises durch Umschaltung auf wenigstens zwei verschiedene Potentiale legen kann, und eine zweite Klemme des Stromkreises auf einem ersten der beiden Potentiale liegt,
und daß an das zweite Relais ein Schaltsignal zur Verbindung der ersten Klemme mit dem zweiten Potential abgegeben wird und an das erste Relais ein Schaltsignal zum Öffnen gegeben wird, und daß ein einen Fehler der beiden Relais kennzeichnendes erstes Fehlersignal abgegeben wird, wenn ein Stromfluß in dem Stromkreis erkannt wird.

2. Verfahren nach Anspruch 1, **dadurch gekennzeichnet, daß** an das zweite Relais ein Schaltsignal zur Schaltung der ersten Klemme an das erste Potential gegeben wird und an das erste Relais ein Schaltsignal zum Schließen gegeben wird, wenn im vorhergehenden Schritt kein Fehler erkannt wurde, und daß ein einen Fehler der beiden Relais kennzeichnendes Fehlersignal abgegeben wird, wenn ein Stromfluß im Stromkreis erkannt wird.

3. Verfahren nach Anspruch 1 oder 2, **dadurch gekennzeichnet, daß** mehrere Verbraucher mit zugeordneten ersten Relais parallel zu den beiden Klemmen geschaltet sind und Fehler in einzelnen und/oder mehreren der Relais erkannt werden.

4. Verfahren nach einem der Ansprüche 1 bis 3, **dadurch gekennzeichnet, daß** ein drittes Relais vorgesehen ist, über das die zweite Klemme mit einem der beiden Potentiale verbunden werden kann.

5. Verfahren nach Anspruch 4, **dadurch gekennzeichnet, daß** durch Schalten des dritten Relais eine Fehlfunktion des zweiten Relais und umgekehrt festgestellt wird.

6. Verfahren nach einem der vorhergehenden Ansprüche, **gekennzeichnet durch** die Verwendung eines Halbleiterschalters an Stelle wenigstens eines der Relais.

## Claims

1. Method for detecting malfunctions of a first relay, operated on d.c. voltage, the switching means of which is connected in series to a load and, depending on the switching position, interrupts or closes the connection to the load in accordance with switching commands, **characterized in that** a current flowing through a circuit containing the switching means is sensed and a malfunction of the first relay, in particular a sticking of the switching means, is detected if the current intensity does not correspond to the current intensity to be expected according to the chosen switching position, furthermore at least a second relay, likewise operated on d.c. voltage, is provided and can apply at least two different potentials to a first terminal of the circuit by means of switching over, and a second terminal of the circuit lies at a first of the two potentials, and **in that** a switching signal for connecting the first terminal to the second potential is emitted to the second relay and a switching signal for opening is passed to the first relay, and **in that** a first malfunction signal, identifying a malfunction of the two relays, is emitted if a current flow in the circuit is detected.

2. Method according to Claim 1, **characterized in that** a switching signal for switching the first terminal to the first potential is passed to the second relay and a switching signal for closing is passed to the first relay if no malfunction was detected in the previous step, and **in that** a malfunction signal identifying a malfunction of the two relays is emitted if a current flow in the circuit is detected.

3. Method according to Claim 1 or 2, **characterized in that** a plurality of loads are connected with the assigned first relay in parallel with the two terminals and malfunctions in one and/or more of the relays are detected.

4. Method according to one of Claims 1 to 3, **characterized in that** a third relay is provided, via which the second terminal can be connected to one of the two potentials.

5. Method according to Claim 4, **characterized in that**, by switching the third relay, a malfunction of the second relay is established, and vice versa.

6. Method according to one of the preceding claims, **characterized by** the use of a semiconductor switch in place of at least one of the relays.

## Revendications

1. Procédé pour reconnaître des branchements défectueux d'un premier relais travaillant en tension continue dont le moyen de commutation est branché en série avec un consommateur et qui, suivant la position de commutation, en fonction des ordres de commutation, interrompt ou établit la liaison avec le consommateur,
**caractérisé en ce qu'**
on détecte le courant traversant un circuit électrique comportant les moyens de commutation et on reconnaît un défaut de fonctionnement du premier relais, notamment le collage du moyen de commutation si l'intensité du courant ne correspond pas à l'intensité prévisible du courant suivant la position de commutation sélectionnée, en outre on a au moins un second relais également branché sur la tension continue, et
qui peut par commutation appliquer une première borne du circuit électrique sur au moins deux potentiels différents et une seconde borne du circuit électrique est reliée au premier des deux potentiels, et on émet au second relais un signal de commutation pour relier la première borne au second potentiel et au premier relais un signal de commutation pour ouvrir, et
un premier signal de défaut est émis, caractérisant un défaut des deux relais si l'on détecte un passage de courant dans le circuit de courant.

2. Procédé selon la revendication 1,
**caractérisé en ce qu'**
on émet un signal de commutation au second relais pour commuter la première borne sur le premier potentiel et on émet un signal de commutation au premier relais pour fermer si, dans l'étape précédente, aucun défaut n'a été détecté, et
on émet un signal de défaut caractérisant un défaut des deux relais si un passage de courant a été détecté dans le circuit de courant.

3. Procédé selon l'une quelconque des revendications 1 ou 2,
**caractérisé en ce que**
plusieurs consommateurs sont branchés avec le premier relais associé, en parallèle sur les deux bornes et on détecte un défaut dans un et/ou plusieurs des relais.

4. Procédé selon l'une quelconque des revendications 1 à 3,
**caractérisé par**
un troisième relais pouvant relier la seconde borne à l'un des deux potentiels.

5. Procédé selon la revendication 4,
**caractérisé en ce que**
par commutation du troisième relais, on constate un défaut de fonctionnement du second relais et inversement.

6. Procédé selon l'une quelconque des revendications précédentes,
**caractérisé en ce qu'**
au moins l'un des relais est un commutateur semi-conducteur.
